## Europäisches Patentamt
## European Patent Office
## Office européen des brevets

(19)

(11) Numéro de publication: **0 159 257**
**B1**

(12) # FASCICULE DE BREVET EUROPÉEN

(45) Date de publication du fascicule du brevet:
**18.05.88**

(51) Int. Cl.⁴: **G 01 R 19/00,** G 01 R 15/00, G 01 R 15/12, G 01 R 15/08

(21) Numéro de dépôt: **85400621.0**

(22) Date de dépôt: **29.03.85**

(54) Circuit électronique pour la mesure des signaux très faibles à potentiel élevé.

(30) Priorité: **30.03.84 FR 8405021**

(43) Date de publication de la demande:
**23.10.85 Bulletin 85/43**

(45) Mention de la délivrance du brevet:
**18.05.88 Bulletin 88/20**

(84) Etats contractants désignés:
**DE GB NL**

(56) Documents cité:
**DE-A-2 219 905**

**SIEMENS-ZEITSCHRIFT, vol. 48, no. 9, septembre 1974, pages 591-596; A. HEDERER et al.: "Messung von schnellveränderlichen Grössen auf hohem elektrischem Potential"**
**CONTROL AND INSTRUMENTATION, vol. 11, no. 2, février 1979, page 7; R. WIDLAR: "New op-amp is capable of floating mode operation"**

(73) Titulaire: **ASSOCIATION POUR LA RECHERCHE ET LE DEVELOPPEMENT DES METHODES ET PROCESSUS INDUSTRIELS (ARMINES), 60, Boulevard Saint- Michel, F-75272 Paris Cédex 06 (FR)**

(72) Inventeur: **Nguyen Tan Tai, Paul, 56, rue des Pyrénées, F-75020 Paris (FR)**
Inventeur: **Henon, Jean- Paul, 3, rue de Nancy, F-78000 Versailles (FR)**

(74) Mandataire: **Chevallier, Robert Marie Georges, Cabinet BOETTCHER 23, rue La Boétie, F-75008 Paris (FR)**

EP 0 159 257 B1

## Description

L'invention a pour objet un procédé et un circuit électronique utilisable particulièrement pour la mesure des signaux ayant de très faibles amplitudes et se trouvant à un potentiel continu très éloigné de celui de la terre.

En spectrométrie, il est souvent nécessaire d'utiliser un circuit multiplicateur d'électrons pour réaliser une première amplification de signaux de courant, dont la sortie se situe à un potentiel de plus de 1 000 V par rapport à la masse ou terre. Ces signaux ont, dans la plupart des cas, des amplitudes infimes. Dans les appareils de mesure connus, ces signaux sont d'abord mis au niveau du potentiel de la terre à l'aide de capacités ou de transformateurs d'isolation. Une résistance de grande valeur permet de convertir les courants en tensions. Or, on sait que la puissance de bruit d'une résistance R est égale a 4KT x R. Au moment de la mesure, ce bruit s'ajoute donc aux faibles signaux en plus de ceux qui sont introduits aussi par les câbles de connection dont l'emploi est souvent nécessaire dans ces circonstances d'utilisation.

Il en est ainsi, par exemple, en analyses par rayons-X ou par microsonde-X. Les signaux sortant d'un détecteur proportionnel se trouvent à un potentiel supérieur à + 1 000 V par rapport à la terre; ils sont transférés aux appareils de mesure à travers une capacité et une résistance de 1 gigohm (1 GΩ) montées en série. L'amplitude du bruit introduit par cette résistance, à la température ambiante et pour un comptage de 10 000 coups par seconde, est de 0,4 mV eff., ce qui est de l'ordre de grandeur des signaux (1 mV). Ce bruit introduit par la résistance est donc important. Il oblige à ralentir le comptage pour l'exécution de mesures correctes. Les durées des analyses sont considérablement allongées.

Il en est de même, dans les cas de spectromètres Auger équipés d'analyseur de type dispersif dans lesquels des courants de quelques centaines de picoampère sont ramenés des hautes tensions à la masse commune par des capacités ou des transformateurs d'isolement. Ces moyens de couplage en courant alternatif déterminent, dans ce cas, les différentes méthodes de spectrométrie.

Dans le cas des spectromètres Leed-Auger équipés d'analyseur à champs retardateurs, le transfert des signaux aux appareils de mesures se fait souvent pas un transformateur d'isolement.

Il existe dans le document DE-A-2 219 905 la description d'un procédé et d'un appareil destinés précisément à la mesure de signaux faibles à des potentiels élevés à l'aide d'un transformateur d'isolement.

Or on sait que le niveau des bruits mélangés aux signaux est important.

Pour y remédier dans les spectromètres mentionnés plus haut on utilise la méthode qui consiste à moduler le potentiel des grilles de l'analyseur, et par détection synchrone sur la première harmonique de la fréquence, à obtenir ainsi la courbe de la distribution des électrons émis. Pour extraire d'autres informations, il est nécessaire de réaliser la détection synchrone réglée sur la deuxième harmonique. Cette méthode est pénalisée par les niveaux élevés du bruit. Les filtrages nécessaires allongent démesurément les temps d'analyses par spectrométrie.

Le but principal de l'invention est de parvenir à mesurer les signaux de très faibles amplitudes à potentiel élevé ou très élevé par rapport à la terre, en courant continu, comme les signaux provenant éventuellement d'un détecteur, sans diminution du rapport signal sur bruit et sans que la liaison des circuits actifs souffre des bruits dus à une éventuelle liaison par câbles, en profitant de la meilleure sensibilité des détecteurs ou des analyseurs.

Un but secondaire de l'invention est de permettre un gain de temps sur les mesures des signaux faibles noyés dans des bruits par un filtrage efficace améliorant le rapport signal sur bruit.

On atteint le but principal indiqué par un circuit électronique selon les charactéristiques de la revendication 1.

Ce circuit électronique est constitué par la combinaison de deux parties dans laquelle la première partie comprend un amplificateur de tension ou de courant lié en courant continu à la source des signaux, par exemple à la sortie d'un multiplicateur d'électrons et, dans ce cas, cet amplificateur est un électromètre. Il est suivi par au moins un amplificateur de courant. Lorsque la tension de mode commun du signal est très élevé, la première partie du circuit reçoit une alimentation qui lui est propre et qui est substantiellement au niveau du potentiel des signaux, par exemple à la haute tension de sortie du multiplicateur d'électrons.

La deuxième partie du circuit, selon l'invention, réalise le transfert sensiblement au niveau du potentiel de la masse des appareils de mesure des signaux de courant provenant de la première partie. Quand il s'agit de signaux en courant continu, cette deuxième partie comprend au moins un transistor, le plus souvent une série de transistors, bipolaires ou à effet de champ, de polarité et de tenue en tension convenable. Le ou les transistors sont montés en base commune ou en amplificateurs de courant. Ils peuvent être de type Darlington ou à montages composites. Le montage est en série lorsqu'il est nécessaire d'utiliser plusieurs transistors pour partager la différence de tension. Dans ce cas, une série de résistances d'égale valeur permet de polariser les transistors. La série de résistances doit joindre, d'un côté le circuit d'alimentation de la première partie du circuit décrite précédemment, de l'autre la masse commune. Le transfert des signaux de courant se fait vers la masse commune, par le collecteur du dernier transistor, dans le cas d'une série, et par une résistance reliée à la masse commune. Les mesures de tensions des signaux s'effectuent aux bornes de cette résistance. Ces tensions peuvent être éventuellement amplifiées par au moins un amplificateur, soit en liaison courant continu, avec réglages par commandes externes, si nécessaires, soit par détections d'impulsions, mises en formes et intégrations. La sortie de ce dernier étage constitue la fin de la deuxième partie du circuit selon l'invention.

Il est souhaitable, quand les signaux à mesurer sont accompagnés de bruits gênants, d'utiliser, dans le cadre de l'invention, une troisième partie placée avant ou après la deuxième partie du circuit. Selon l'invention, cette troisième partie réalise un échantillonage des signaux déjà amplifiés et constitue un moyen de filtrage et de préservation contre les bruits. Elle est constituée par une porte analogique, au moins, intercalée sur le chemin de circulation du signal, à un endroit choisi du circuit, selon l'utilisation envisagée. Ainsi, dans le cas de l'emploi de l'invention en spectrométrie Auger, l'échantillonnage du signal est préférentiellement effectué, au niveau du potentiel élevé de la première partie du circuit. La porte analogique est alors insérée entre l'amplificateur d'entrée de signal et l'amplificateur de courant. Dans ce cas précis, lé circuit constituant cette porte reçoit les mêmes tensions d'alimentation qui sont réservées à la première partie du circuit. De cette façon, le signal échantillonné est transmis, à travers la deuxième partie du circuit, sans être affecté par les éventuelles imperfections de ce dernier.

Le signal échantillonné est alternatif, il est évident que sa transmission vers le potentiel de masse commune peut alors être effectuée à travers un condensateur au moins, à valeur convenable, et constituant la deuxième partie du circuit pour relier la sortie de la première partie du circuit au potentiel commun. Mais ce cas est limité à la transmission des signaux alternatifs assez rapides.

Dans d'autres cas d'emploi de l'invention, la troisième partie citée ci-dessus peut être placée à la suite de la deuxième partie du circuit pour réaliser l'échantillonnage du signal à ce niveau.

L'opération d'échantillonnage se fait dans tous les cas au moyen de la porte analogique grâce à un signal de période appropriée provenant d'un circuit externe à celui de l'invention et qui commande l'ouverture et la fermeture de cette porte. La porte est polarisée de telle façon que l'on puisse faire des mesures, soit avec, soit sans échantillonnage.

La reconstitution ou démodulation du signal échantillonné se fait par des circuits externes qui ne font pas partie de l'invention, selon des techniques bien connues comme la détection synchrone ou synchrodyne, qui reconstituent le signal avant échantillonnage, moyenné, donc avec un rapport signal sur bruit amélioré.

On donnera maintenant, sans intention limitative et sans exclure aucune variante, une description de deux exemples de réalisation.

On se reportera aux dessins annexés dans lesquels:

- la figure 1 est un schéma d'un premier circuit électronique conforme à l'invention avec une troisième partie d'échantillonnage placée après la deuxième partie,

-la figure 2 est un schéma d'un deuxième circuit électronique conforme à l'invention avec une troisième partie d'échantillonnage placée avant la deuxième partie.

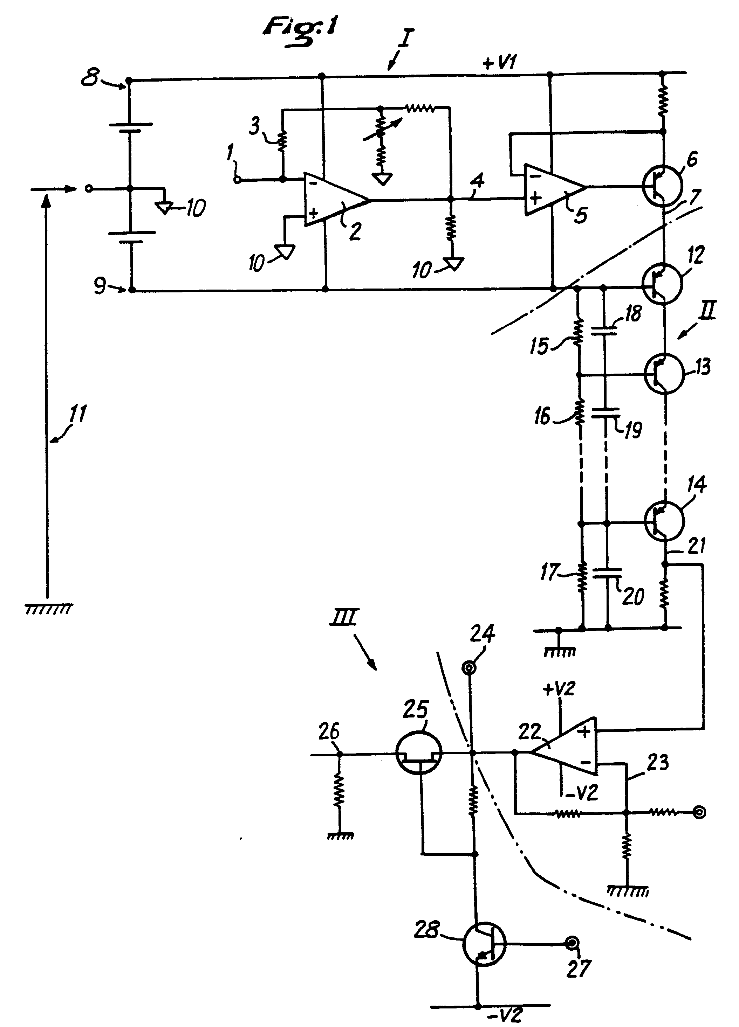

On se reportera d'abord à la figure 1.

La première partie I du circuit, selon l'invention, est séparée sur cette figure 1 de la deuxième partie II par un trait mixte. Le signal de courant à mesurer arrive à cette première partie 1. Il est appliqué directement à une entrée 1 d'un amplificateur 2. Dans le cas de mesure de tension, la liaison de l'amplificateur 2 aux signaux se fait en 1 par une résistance de valeur convenable avec une résistance 3 pour procurer un gain choisi. Le signal passant par l'amplificateur 2 est envoyé en continu par un fil 4 à une entrée d'un amplificateur ce courant constitué dans ce cas par un amplificateur 5 et un transistor PNP 6; les signaux sortent par le collecteur 7 du transistor 6. Cet ensemble, non limitatif en composants, constitue la première partie I du circuit selon linvention. Il est alimenté par une source de tension isolée de la masse commune et ayant sur la figure des bornes opposées 8 et 9 avec un point milieu 10. Le potentiel du point 10 est celui de la référence du circuit de cette première partie I. La différence de potentiel de la source par rapport à la masse commune de l'ensemble instrumental se trouvant à la terre, par exemple, est représentée en 11. La partie haute tension de 11 est donc reliée à la masse 10 de la première partie I du circuit qui ce trouve alors à une tension de mode commun élevée.

La deuxième partie du circuit selon l'invention, désignée sur la figure par la référence II, est limitée par rapport à une troisième partie III par un trait mixte double.

Le transfert des signaux à travers la différence de potentiel entre le circuit de la première partie I et le potentiel de masse des appareils suivants est fait à travers une série de transistors montés en base commune, ou drain commun, dont le nombre dépend de la valeur du potentiel à transférer. Dans cet exemple de réalisation, il existe dans ce circuit d'abaissement du potentiel une série de trois transistors bipolaires PNP, 12, 13 et 14. Ils sont polarisés par des résistances mises en série 15, 16 et 17 avec des capacités de filtrage 18, 19 et 20. Cet ensemble de transistors et son pont de polarisation effectuent la jonction en courant continu entre le potentiel de la première partie I du circuit, selon l'invention, à l'entrée ou point commun des éléments 15, 18 et 12 au potentiel de la masse commune des éléments 17, 20 et 14. Les signaux du transistor 6 sortent par le collecteur 21 du dernier transistor 14. Ils sont amplifiés par au moins un amplificateur 22 dont une entrée 23 peut recevoir une polarisation du niveau du signal continu recueilli à sa sortie 24 où un relevé des mesures peut être effectué.

Dans de nombreuses circonstances, le circuit de l'invention peut être limité aux deux parties I et II. Le signal ayant été préalablement amplifié avant d'être mis au potentiel de la masse des appareils de mesure, il est prépondérant par rapport aux bruits introduits par la partie II du circuit. Mais, si le signal est accompagné de bruits gênants qui sont amplifiés avec lui, il est avantageux d'utiliser la partie III du circuit. Cette troisième partie effectue des opérations d'échantillonnage du signal provenant de la sortie 24 de la partie II. Le signal arrivant à la sortie 24 est envoyé a travers une porte analogique 25 à une résistance de charge, en 26. Un signal de fréquence appropriée appliqué à l'entrée 27 d'un transistor 28 de commande de la porte 25 permet à la charge 26 de recevoir des échantillons du signal venant de la sortie 24.

Le signal échantillonné recueilli en 26 peut être traité par un circuit de reconstitution, connu en soi, qui lui fait suite et qui n'est pas inclus dans le circuit de l'invention.

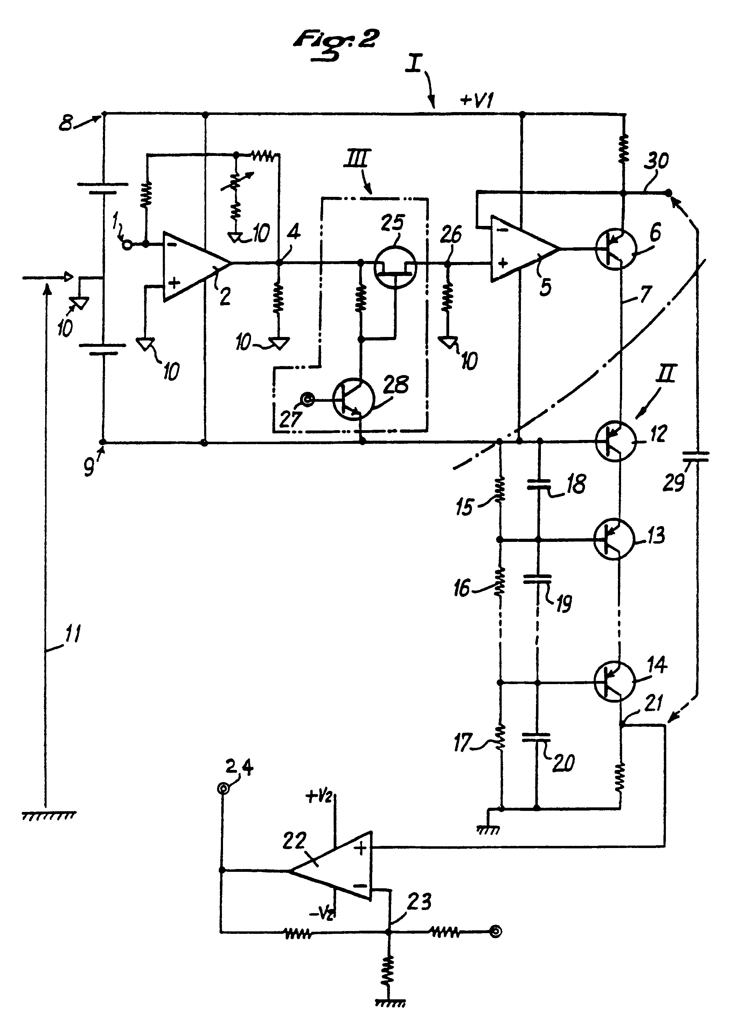

On se reportera maintenant à la figure 2 pour décrire un deuxième exemple d'un circuit selon l'invention. Pour fixer les idées, ce circuit est prévu pour son application à la spectrométrie Auger et, a ce titre, n'est nullement limitatif.

Le schéma est semblable en tout point à celui du premier exemple de la figure 1, sauf en ce qui concerne l'emplacement du circuit d'échantillonnage constituant la troisième partie du circuit selon l'invention. Cette troisième partie III, identique en elle-même à celle décrite précédemment et entourée d'un trait mixte pour mieux la faire apparaître, est montée de la façon suivante. La porte analogique 25 est intercalée entre d'une part la sortie 4 de l'amplificateur 2, d'autre part l'entrée de l'amplificateur 5. Le transistor de commande 28 de la porte 25 est alimenté par la même tension 9 que l'ensemble de la première partie I. L'entrée 27 du transistor 28 peut recevoir un signal de fréquence appropriée pour la commande de la porte, par un circuit non inclus dans celui de l'invention. Dans ce cas, l'amplificateur 5-6 transmet des échantillons de signaux sous forme de courant, vers la masse commune, à travers le circuit de la deuxième partie II déjà décrite précédemment. On trouve les signaux à la sortie 24 de l'amplificateur 22. Ils soit alors reconstitués comme indiqué plus haut par des circuits non inclus dans l'invention.

Il est bien entendu que dans certains cas, un condensateur 29 de valeur convenable peut remplacer l'ensemble des éléments 15, 16, 17, 18, 19, 20, 12, 13 et 14 pour transmettre les signaux alternatifs vers la masse commune. Ce condensateur relie alors en courant aliternatif le point 30 de sortie de l'amplificateur 5-6 au point 21 d'entrée de l'amplificateur 22 par l'intermédiaire d'une résistance non représentée.

A titre indicatif, on précisera que l'on peut utiliser dans les circuits qui viennent d'être décrits les composants suivants, disponibles dans le commerce pour l'amplificateur 2: AD 515 K; pour les amplificateurs 2, 5, 22,: LF 355; pour la porte analogique 25: 2N 4091; pour le transistor 28: BC 437 b NPN; pour le transistor 6: BC 307 b PNP; pour les transistors 12, 13, 14: BFW 43 PNP (Ve commune 180 V).

Ainsi, il apparaît que l'invention apporte un nouveau procédé de mesure particulièrement utile dans la spectrométrie Leed-Auger, XPS. En effet, il permet la spectrométrie sans modulations ou découpage du faisceau d'électrons, évitant les fonctionnements en régimes dynamiques élevés des optiques dont on ne connaît pas bien les fonctions de transferts et donc leurs produits de convolutions sur les signaux. Le circuit de l'invention permet de mesurer directement les résultats donnés par le type d'analyseur utilisé, avec une grande sensibilité de mesures et une meilleure sensibilité d'analyse grâce au grand rapport signal sur bruit. La réponse du circuit composé d'éléments actifs est rapide. L'accélération des mesures spectrométriques pour suivre un phénomène est possible. De plus, le circuit de l'invention réalise les mesures en aval de l'analyseur, le passage du mode analyse au mode visualisation en électrons secondaires se fait par simple commutation, sans réglage des paramètres contrairement à ce qu'exige la méthode du découpage du faisceau d'analyse. L'automatisation du spectromètre s'en trouve facilitée. On notera que le circuit selon l'invention fonctionne aussi bien en amplificateur d'impulsions et peut être suivi éventuellement par un compteur ou un intégrateur.

Ainsi qu'on l'a déjà dit, le circuit de l'invention est utilisable pour des mesures de courant continu et alternatif. Dans le cas de signaux en courant alternatif, la série des transistors 12 à 14 dans la partie II peut être remplacée par une série de capacités, ou de transformateurs ou de moyens de transmission à fibres optiques. Son utilisation en spectrométries de rayons-X et microsonde-X apporte l'intérêt de son faible niveau de bruit, de son faible encombrement; il peut remplacer, dans ce cas, tout le système de comptage et servir de moyen de comptage. Dans ce cas, il s'intègre parfaitement à l'ensemble d'un appareil miniaturisé.

Il est à remarquer aussi que le circuit de l'invention peut apporter ses avantages aux appareils utilisant des signaux provenant de capteurs et souffrant d'une influence électromagnétique sévère.

**Revendications**

1. Circuit électronique pour la mesure de signaux très faibles à potentiel élevé comparables à ceux d'un spectromètre, comprenant une première partie (I) constituée par au moins un amplificateur (2) directement relié en courant continu à une source des signaux suivi d'au moins un amplificateur de courant (5), cette première partie (I) ayant une tension d'alimentation substantiellement au niveau du potentiel de la source des signaux, et une deuxième partie (II) constituée par au moins un circuit d'abaissement du potentiel sensiblement au niveau de la masse des appareils de mesure des signaux, caractérisé en ce que, pour des signaux en courant continu, le circuit d'abaissement du potentiel comprend au moins un transistor (12) recevant les signaux de courant provenant de la première partie (I) du circuit, par son émetteur ou source, et les transmettant à la masse commune des appareils qui suivent le circuit par son collecteur, ce transistor étant polarisé par une résistance (15) au moins, reliant un point à potentiel élevé de la première partie (I) du circuit à la masse commune.

2. Circuit électronique selon la revendication 1 caractérisé en ce que la deuxième partie (II) comprend plusieurs transistors (12, 13, 14) montés en série, reliés du collecteur du premier (12) à l'émetteur du deuxième (13) et ainsi de suite, le dernier transistor (14) ayant son collecteur relié par une résistance de charge au potentiel de la masse commune, ces transistors (12, 13, 14) étant polarisés chacun par des résistances (15, 16, 17) branchées respectivement entre base et collecteur et reliées entre elles en série entre un point au potentiel de la première partie (I) du circuit et un point au potentiel de la masse commune, ces résistances (15, 16, 17) partageant la différence de potentiel entre les transistors à des valeurs adéquates.

3. Circuit électronique selon la revendication 1 caractérisé en ce que, pour des signaux en courant alternatif, le circuit d'abaissement du potentiel comprend au moins un moyen choisi entre un condensateur, un transformateur, un moyen de transmission par fibre optique.

**Patentansprüche**

1. Elektronische Schaltungsanordnung zur Messung sehr schwacher Signale hoher Spannung, vergleichbar den Signalen eines Spektrometers, umfassend einen ersten Schaltungsteil (I), der mindestens aus einem gleichstrommäßig direkt an eine Signalquelle angeschlossenen Verstärker (2) besteht, dem mindestens ein Stromverstärker (5) folgt, wobei die Speisespannung dieses ersten Schaltungsteiles (I) im wesentlichen auf dem Potentialniveau der Signalquelle liegt, und einen zweiten Schaltungsteil (II) der aus mindestens einer Schaltung zum Absenken der Spannung im wesentlichen auf das Niveau der Masse der Signalmeßgeräte besteht, dadurch gekennzeichnet, daß für Gleichspannungssignale die Spannungssenkungsschaltung mindestens einen Transistor (12) aufweist, der die von dem ersten Schaltungsteil kommenden Stromsignale über seinen Emitter oder seine Source empfängt und sie an die gemeinsame Masse der der Schaltungsanordnung nachgeschalteten Geräte über seinen Kollektor weiterleitet, wobei die Arbeitsspannung des Transistors über mindestens einen Widerstand (15) festgelegt ist, der einen Punkt hohen Potentials des ersten Schaltungsteiles (I) mit der gemeinsamen Masse verbindet.

2. Elektronische Schaltung nach Anspruch 1, dadurch gekennzeichnet, daß der zweite Schaltungsteil (II) mehrere in Serie geschaltete Transistoren (12, 13, 14) enthält, wobei der Kollektor des ersten Transistors (12) mit dem Emitter des zweiten Transistors (13) verbunden ist usw. und der Kollektor des letzten Transistors über einen Ladewiderstand mit dem Potential der gemeinsamen Masse verbunden ist, und daß die Arbeitsspannung dieser Transistoren (12, 13, 14) jeweils über zwischen Basis und Kollektor geschaltete Widerstände (15, 16, 17) festgelegt ist, die untereinander zwischen einen Punkt mit dem Potential des ersten Schaltungsteiles (I) und einen Punkt der gemeinsamen Masse in Serie geschaltet sind, wobei diese Widerstände (15, 16, 17) den Potentialunterschied zu gleichen Teilen zwischen den Transistoren aufteilen.

3. Elektronische Schaltung nach Anspruch 1, dadurch gekennzeichnet, daß für Wechselstromsignale die Schaltung zum Absenken des Potentials mindestens ein unter einem Kondensator, einem Transformator und einer Einrichtung zur Übertragung mittels optischer Fasern ausgewähltes Element enthält.

**Claims**

1. Electronic circuit for measuring very weak high voltage signals comparable to those of a spectrometer, incorporating a first part (I) constituted by at least one amplifier (2) linked directly in direct current to a source of signals, followed by at least one amplifier of current (5), this first part (I) having a supply voltage substantially of the voltage level of the source of signals, and a second part (II) comprising at least one circuit to lower the voltage, essentially to the level of the mass of the signal measuring apparatus, characterised in that, for signals in direct current, the circuit to lower the voltage includes at least one transistor (12), receiving the signals coming from the first part (I) of the circuit, by its emitter or source, and transmitting them to the common mass of the apparatus that follow the circuit by its collector, this transistor being polarised by one resistor 15 at least, linking a point of high voltage of the first part of the circuit (I) to the common mass.

2. Electronic circuit according to Claim 1, characterised in that the second part (II) includes several transistors (12, 13, 14) mounted in series, linked from the collector of the first (12) to the emitter of the second (13) and so on, the last transistor (14) having its collector linked by load resistance to the voltage of the common mass, these transistors (12, 13, 14) being each polarised by resistors (15, 16, 17) connected respectively between base and collector, and linked between themselves in series between a point at the voltage of the first part (I) of the circuit, and a point at the voltage of the common mass, these resistors (15, 16, 17) dividing the difference in voltage between the transistors to adequate values.

3. Electronic circuit according to Claim 1, characterised in that, for signals in alternating current, the circuit to lower the voltage includes at least one means chosen from a condenser, a transformer, a means of transmission by fibre optics.

Fig.1

*Fig.2*